# EUROPEAN PATENT SPECIFICATION

(11) **EP 0 460 304 B1**
(45) Date of publication and mention of the grant of the patent: **26.04.1995**
(21) Application number: 90306061.4
(22) Date of filing: 04.06.1990
(51) Int. Cl.: H05K 13/02, B65G 47/256

(54) **Orientation of tube carriers for electronic devices**
Orientierung von Trägerröhren für elektronische Vorrichtungen
Orientation de supports tubulaires pour dispositifs électroniques

(43) Date of publication of application: 11.12.1991
(73) Proprietor: I.C. EQUIPMENT PTE LTD., Singapore 2056 (SG)
(72) Inventor: Boh, Teck Keong, Singapore 2057 (SG); Lee, Sun Long, Singapore 1231 (SG)
(74) Representative: Cheyne, John Robert Alexander Mackenzie

(56) References cited:
- DE-C- 425 768
- GB-A- 2 163 137
- US-A- 4 775 279

## Description

This invention relates to the orientation of tube carriers for electronic devices.

In the manufacture of integrated circuits and other electronic devices, the devices are normally electrically tested, marked with a device code and/or inspected for cosmetic, visual and mechanical defects before they are shipped to a customer. Special device handlers have been used which will place the device to be tested, marked and/or inspected in position. In such device handlers, the testing or marking or inspection speed has been usually very fast in the order of 1000 to 10000 devices per hour and it can be even more. The reason for this high speed is that the testing or marking or inspection is of high repeatability in nature and the availability of systems that use high speed electronic timing signals has made it worthwhile for manufactures to invest in these expensive systems to remain competitive.

Electronic devices are usually supplied in a tube carrier which contains a large number of the devices. For testing or other operations, a known procedure is for an operator to hold the tube carrier and pour the devices onto an input track of the device handlers so that the devices will slide at an inclined angle under gravity to the test/mark/inspect position. Upon completion of this process, the devices will be released by electro-mechanical means and will be allowed to continue to slide under gravity into a waiting tube carrier inserted manually by the operator at the output of the device handler.

The manual loading of tube carriers into the device handler has left much to be desired. A particular disadvantage of such a system is that the manufacturer becomes very heavily dependent on scarce and increasingly expensive labour to operate the machine continuously. Retaining workers always poses a problem in difficult labour market situations and also the quality of output is often poor.

The ineffective manual method has led to the invention of bulk tube handlers to load and to unload the tube carriers automatically via the device handler. In some prior bulk tube handlers, the bulk tube handler has performed a separating function, to feed tube carriers one at a time, by means of rotating sprocket drum mechanisms which are driven automatically. A disadvantage of these prior systems was that they caused tube carriers that are rectangular in cross-section to interlock with each other, at times resulting in frequent intermittent stoppages. The operator had to clear the interlocking problem before the handler could resume operation. Such systems suffered from poor productivity, recorded low machine utilisation and the operator had to spend considerable time attending to the machine.

US-A-4775279 discloses a method of arranging tube carriers in a desired orientation, in which individual tube carriers are automatically transferred from a hopper to an orientor station. Orientation of a tube carrier in the orientor station is dependent on the fitting of an orientor collar over the end of the tube carrier. The collar is then rotated with the tube carrier into a desired orientation.

According to the present invention there is provided a method of arranging tube carriers for electronic devices in a desired orientation, the tube carriers being of non-circular cross-section, the method comprising:
a) feeding the tube carriers, in a direction transverse to their longitudinal axis, through a gap between a guide member and a rotating roller, the gap being sufficiently wide to permit each tube carrier to pass through the gap only in permitted orientations about the longitudinal axis of the tube carrier;
b) detecting which of the permitted orientations is adopted by each tube carrier upon passing through the gap; and
c) unless the orientation of a tube carrier is a desired orientation, rotating that tube carrier about its longitudinal axis to the desired orientation.

Preferably, the rotating roller on the side facing the guide member travels in a direction against the feed direction of the tube carriers. Preferably also, the guide member is a second roller. The rotating roller may rotate continuously in one direction and the second roller may rotate alternately in opposite directions.

In a preferred embodiment the tube carriers are moved through the gap between the guide member and the rotating roller under the force of gravity. After passing through the gap, the tube carriers may be stacked in a buffer to maintain their orientation. The buffer may be provided with a sensor responsive to the orientation of each tube carrier. The orientation may be performed by rotating the tube carrier in a direction which is determined in response to the output of the sensor.

Preferably the orientation of each tube carrier is performed by an orientator which receives each tube carrier in turn and rotates it to the desired orientation, the orientator being coupled to a rotational position sensing device which comprises a disc unit, which rotates in unison with the orientator, and a plurality of sensing units which sense the rotational displacement of the disc unit. The disc unit may comprise a position disc and a direction disc, and the sensing units may comprise a home sensor and an orientation position sensor, which are responsive to the position disc, and a rotation direction sensor which is responsive to the direction disc, the position disc having peripheral notches disposed, respectively, to actuate the home sensor, when the disc unit is in a home position, and the orientation position sensor when the disc unit has rotated to either one of two orientation positions by rotation in one or the other direction from the home position, and the direction disc having a peripheral recess which actuates the rotation direction sensor in the home position and in one, but not the other, of the orientation positions.

For a better understanding of the present invention and to show how it may be carried into effect, reference will now be made, by way of example, to the accompanying drawings, in which:
Figure 1 is a perspective view of a bulk tube handler in accordance with an embodiment of the present invention;
Figure 2 is a detailed cut away side view of the bulk tube handler;
Figure 3 diagrammatically shows the interaction of an input and an output bulk tube handler with a device handler;
Figure 4 is a perspective view of the rotary orientator and a position sensing device;
Figure 5 shows the relationship between the position sensing device and the tube orientator; and
Figure 6 shows some of the different types of tube carriers used in carrying semiconductors/electronic components.

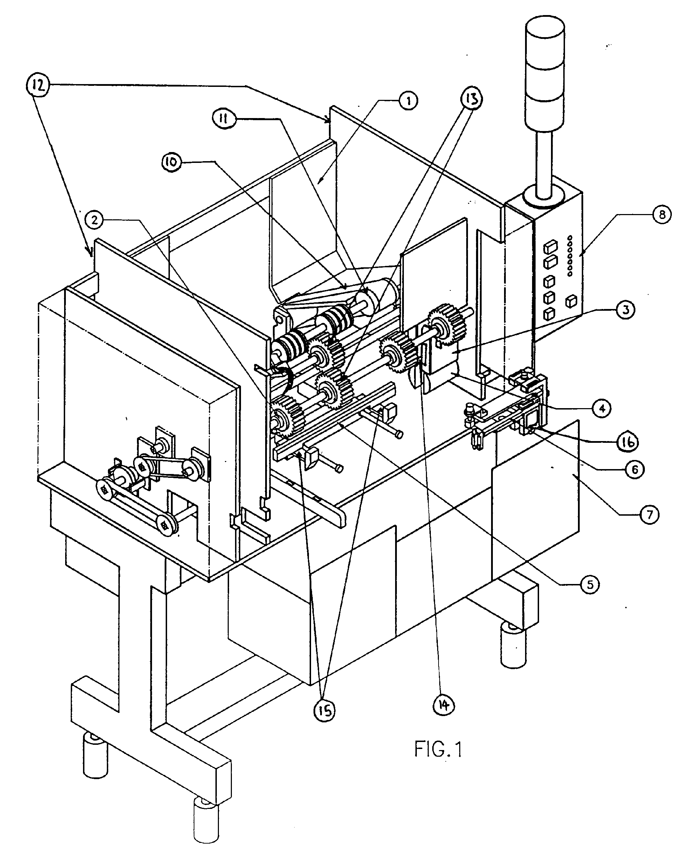

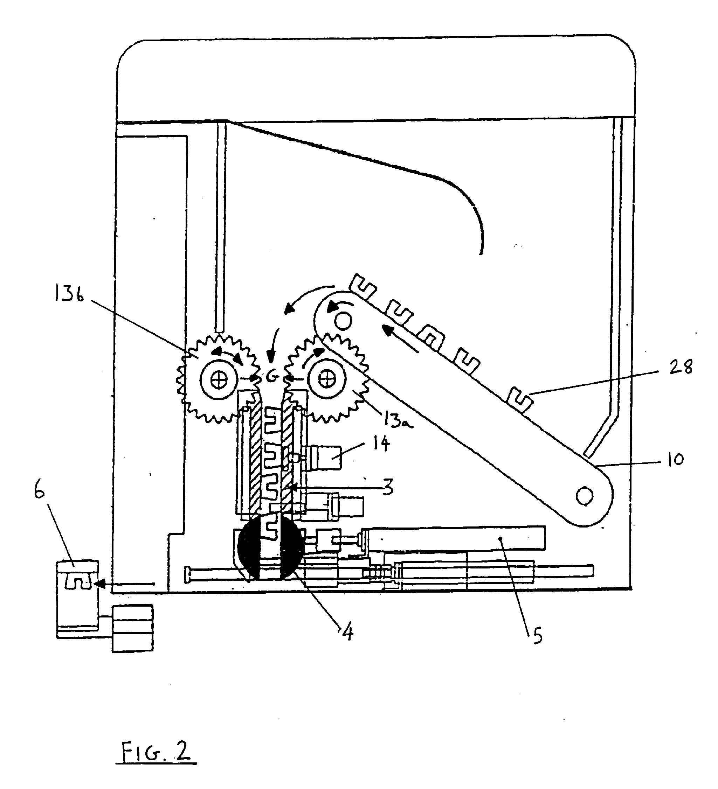

Figures 1 and 2 show a bulk tube handler (BTH) in accordance with an embodiment of the invention. The BTH comprises a manually loaded hopper 1 to store the tube carriers 28 (the capacity of the hopper is 100 tube carriers or more depending on the profile of the tube carrier); a separator assembly 2 to load the tube carriers 28 one at a time in an ordered manner; a buffer column section 3 to ensure that tube carriers 28 are continuously available to feed sufficient devices into the device handler 9; a tube orientator 4 to orient the tube carrier 28 to the desired position as required by the operator; a tube carrier pusher 5 to push the tube carrier 28 forward; a shuttle 6 which holds the tube carrier 28 and turns the tube carrier to load or unload the devices to/from the device handler 9; a tube carrier bin 7 to collect the tube carriers 28 after processing; and a machine control panel 8 for the operator to control the bulk tube handler BTH.

It will be understood that various electronic devices may be presented in the tube carrier 28 such as transistors, integrated circuits, etc. Also, it will be understood that the tube carriers 28 can be emptied to allow devices to be loaded from the device handler 9 and the tube carrier profile can be of any shape so long as it can handle the above mentioned devices or components.

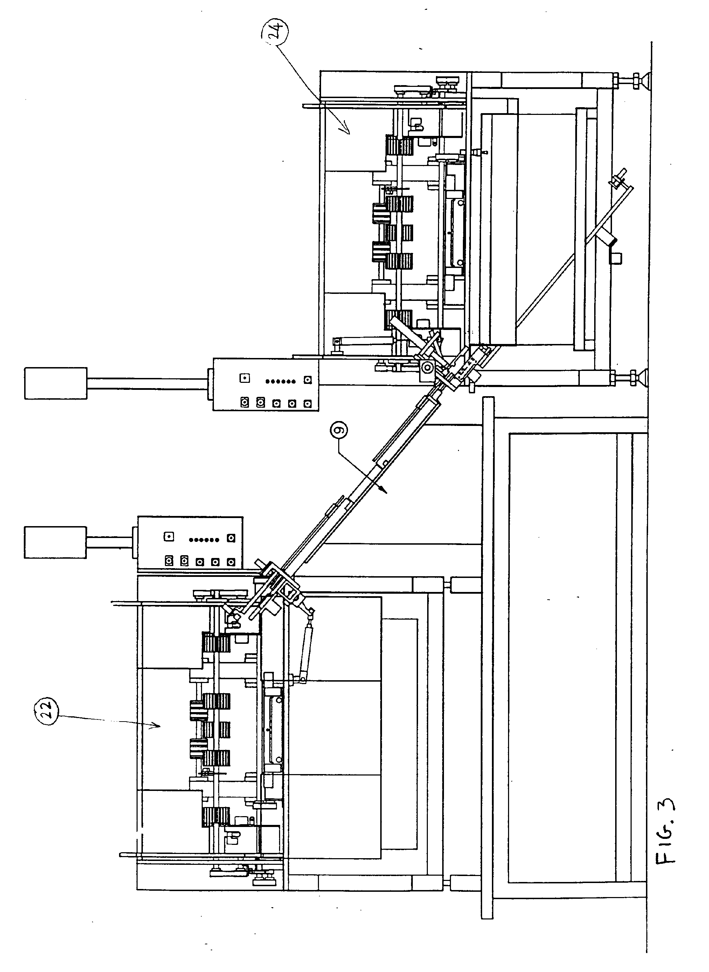

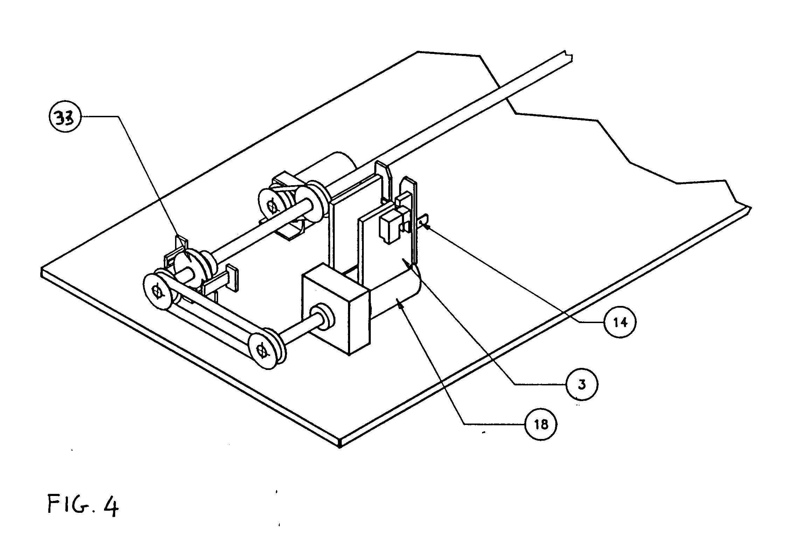

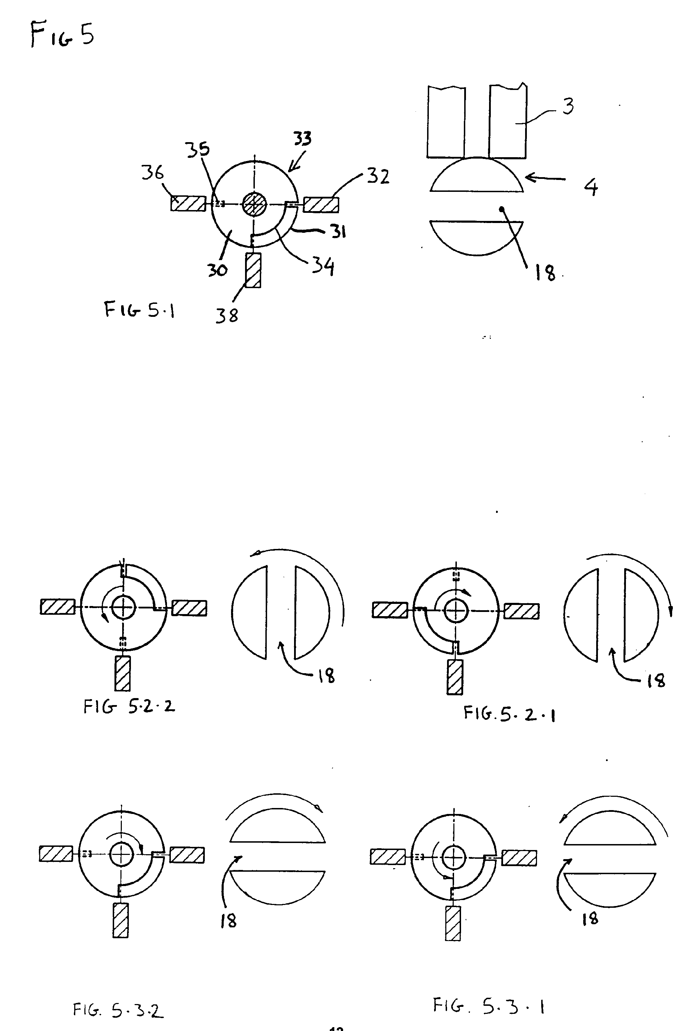

Figure 3 shows how the BTH interfaces with the device handler 9. Two BTHs are shown: one 22 at the input for unloading devices into the device handler 9 and the other 24 at the output for loading the devices back into a tube carrier 28 after processing the devices.

Referring to Figures 1 and 2, the hopper 1 is provided with two belts 10 driven by roller hubs 11 supported by two side plates 12. The hopper is loaded with tube carriers 28 manually by the operator. In operation, the roller hubs 11 rotate and drive the belts 10 such that the tube carrier 28 sitting directly on the belts is carried forward in an inclined upward manner until it reaches a separator assembly where separator rollers 13a, 13b are situated.

The tube carrier 28 then drops vertically under gravity in between the separator rollers 13 which act as separators to transfer the tube carriers one at a time into the buffer column section 3.

The first separator roller 13a, which is located directly below the upper end of the belts 10 rotates continuously in a direction contrary to the feed direction of tube carriers 28 into the buffer column 3, and the second separator roller 13b rotates alternately in opposite directions. Thus, a tube carrier 28 which lands between the rollers but cannot pass through because of its orientation, is rotated by the rollers 13a, 13b until its smallest cross sectional dimension is presented to the gap G between the rollers. In this condition the tube carrier is able to pass through the rollers to the buffer 3.

Whilst the tube carrier 28 is in the buffer column section awaiting orientation by the tube orientator, a sensor 14 mounted at the buffer station pre-records the orientation of the tube carrier 28 and stores it in an electronic memory.

The sensing operation is followed by the release of one tube carrier 28 at a time into the tube orientator 4. The orientator will be signalled electrically from the pre-recorded tube orientation code and will rotate the tube carrier to the desired position accordingly. Rotation is bi-directional either clockwise or anti-clockwise at any pre-fixed angle (for the purposes of explanation, the angle may be assumed to be ninety degrees). With the tube carrier 28 sited properly at the pusher carrier 15, the pusher carrier 15 will be indexed forward together with the tube carrier 28 sitting above it in a horizontal manner into the shuttle assembly 6. The shuttle assembly 6 will clamp the tube and the pusher carrier 15 will retract immediately. The shuttle assembly 6 will tilt with the tube carrier clockwise or anti-clockwise to a pre-set angle (usually between twenty to seventy-five degrees depending on the device handler 9). The devices can thus flow into the device handler 9 from the BTH (i.e. Input BTH) and the devices can be received back into the tube carrier 28 by another BTH (i.e. Output BTH).

Figure 4 shows the design of the tube orientator system which uses a disc unit 33 that registers the position of the tube orientator 4. Once a tube carrier 28 is released into the tube orientator shaft 18, the tube carrier orientation signal fed from the sensor 14 will trigger the tube orientator 4 to move either clockwise or anti-clockwise through ninety degrees. The rotary orientator 4 will rotate ninety degrees followed by a pause. The tube pusher 5 will push the tube carrier forward in a horizontal manner into the shuttle. The pusher 5 will retract to its original position and trigger another signal to activate the disc unit 33 to rotate the tube orientator 4 back to home position. The tube orientator shaft 18 will either turn anti-clockwise ninety degrees or clockwise ninety degrees, in the opposite direction to its prior rotation. Once the tube orientator shaft 18 is back in position, the disc unit 33 will trigger the motor to stop turning. At the same time, a signal will be sent to the buffer column section 3 to release the next tube carrier. The process will be repeated.

Figure 5 shows the linking relationship between the tube orientator shaft 18 and the disc unit 33 and is intended to explain how the principle of tube orientation works. The aim of orientating the tube carrier correctly is to ensure that the devices can be released or be received properly.

The disc unit 33 comprises two discs 30,31 mounted one behind the other on a common shaft. The two discs rotate together so that their relative positions are fixed. The discs are provided with sensors 32, 36, 38 distributed around their periphery.

The first disc 30 is used to determine the direction of rotation of the disc unit 33 from a "home" position shown in Figure 5.1. The disc 30 is provided with a peripheral recess 34 which extends over ¼ of the circumference of the disc 30. When the recess 34 passes beneath the sensor 32, the sensor is triggered to give a "clear" signal.

The second disc 31 is used to determine end positions of rotation in either direction, and is provided with two small peripheral notches 35 disposed 180° apart. When the notches 35 are aligned beneath either the home sensor 36 or the orientation position sensor 38 the respective sensor is triggered to give a "clear" signal. As soon as a notch 35 has passed from beaneath a triggered sensor (36 or 38), the sensor again emits a "block" signal.

The home position of the tube orientator shaft 18 is as shown in Figure 5.1. It will be appreciated that the orientator shaft 18 must rotate through 90° to enable the next tube carrier 28 to drop into it from the buffer 3. The direction of rotation for this purpose is determined in response to the pre-recorded orientation signal from the sensor 14.

Thus the motor 20 will rotate clockwise or anticlockwise until the orientation position sensor 38 of the disc unit 33 detects a "clear" signal as shown in Figures 5.2.1 and 5.2.2. During this rotation, the tube orientator will also rotate in the same direction simultaneously as it is linked by a common belt with a 1:1 transmission ratio. The next tube carrier 28 will then drop into the slot in the orientator shaft 18, and a signal will then be sent to the motor 20 to rotate the disc unit 33 and hence the tube orientator 4. The direction of rotation is determined by the status of the direction sensor 32. With the disc unit 33 oriented as shown in Figure 5.2.1, the rotation direction sensor 32 registers a "block" signal, causing the disc unit 33 to rotate anti-clockwise until the home sensor 36 senses a "clear" signal (Figure 5.3.1.). The motor will then stop immediately. When the disc unit 33 is oriented as shown in Figure 5.2.2, the rotation direction sensor 32 registers a "clear" signal, and the disc unit 33 will rotate clockwise until the home sensor 36 detects a "clear" signal (Figure 5.3.2) causing the motor to stop immediately.

At this juncture, with the tube carrier 28 in the desired horizontal orientation in the tube orientator, the tube carrier 28 is seated at the pusher carrier 15. The tube pusher 5 is then activated and pushes the tube carrier into the shuttle assembly 6. The tube clamper 16 will clamp the tube carrier and the tube pusher will retract.

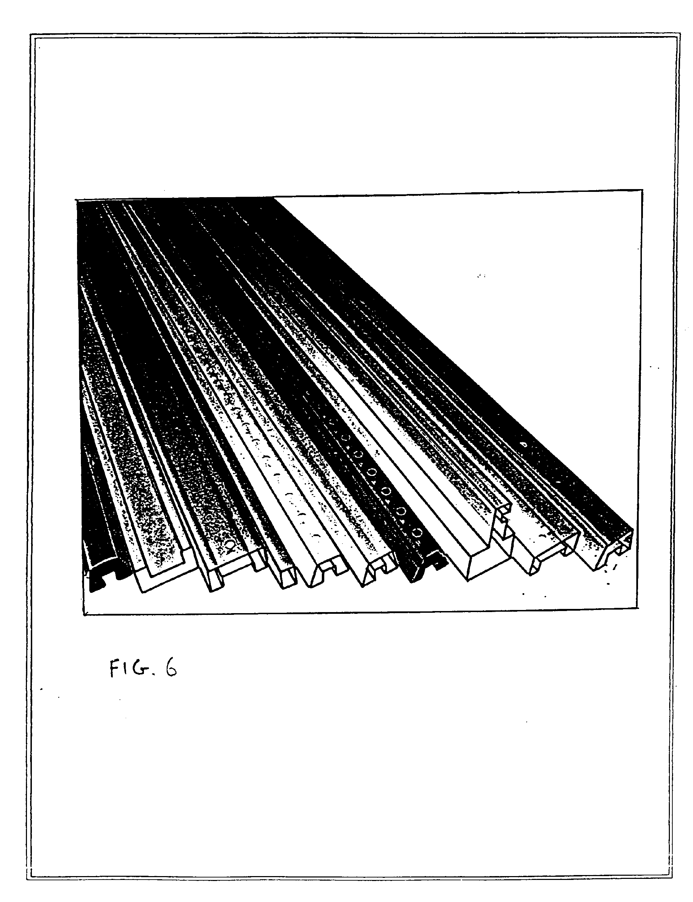

Although in the embodiment described, only one shape of tube carrier is shown, it is intended that the apparatus may be adapted to orient any tube carrier with a non-circular cross section. Figure 6 shows a range of tube carriers which may commonly be used.

## Claims

1. A method of arranging tube carriers for electronic devices (28) in a desired orientation, the tube carriers (28) being of non-circular cross-section, the method comprising:
a) feeding the tube carriers (28), in a direction transverse to their longitudinal axis, through a gap between a guide member (13b) and a rotating roller (13a), the gap (G) being sufficiently wide to permit each tube carrier (28) to pass through the gap (G) only in permitted orientations about the longitudinal axis of the tube carrier (28);
b) detecting which of the permitted orientations is adopted by each tube carrier (28) upon passing through the gap (G); and
c) unless the orientation of a tube carrier (28) is a desired orientation, rotating that tube carrier (28) about its longitudinal axis to the desired orientation.

2. A method as claimed in claim 1, characterised in that the rotating roller (13a) on the side facing the guide member (13b) travels in a direction against the feed direction of the tube carriers (28).

3. A method as claimed in claim 1 or 2, characterised in that the guide member (13b) is a second roller.

4. A method as claimed in claim 3, characterised in that the rotating roller (13a) rotates continuously in one direction and the second roller (13b) rotates alternately in opposite directions.

5. A method as claimed in any one of the preceding claims, characterised in that the tube carriers (28) are moved through the gap (G) under the force of gravity.

6. A method as claimed in any one of the preceding claims, characterised in that, after passing through the gap (G), the tube carriers (28) are stacked in a buffer (3) which is adapted to maintain the orientation of the tube carriers (28).

7. A method as claimed in claim 6 characterised in that the buffer is provided with a sensor responsive to the orientation of each tube carrier (28).

8. A method as claimed in any one of the preceding claims, characterised in that the orientation is performed by rotating the tube carrier (28) in a direction which is determined in response to the output of the sensor (14).

9. A method as claimed in any one of the preceding claims, characterised in that the orientation of each tube carrier (28) is performed by an orientator (4) which receives each tube carrier (28) in turn and rotates it to the desired orientation, the orientator (4) being coupled to a rotational position sensing device which comprises a disc unit (33), which rotates in unison with the orientator, and a plurality of sensing units (32, 36, 38) which sense the rotational displacement of the disc unit (33).

10. A method as claimed in claim 9, characterised in that the disc unit (33) comprises a position disc (31) and a direction disc (30), and in that the sensing unit comprises a home sensor (36) and an orientation position sensor (38), which are responsive to the position disc (31), and a rotation direction sensor (32) which is responsive to the direction disc (30), the position disc (31) having peripheral notches (35) disposed, respectively, to actuate the home sensor (36), when the disc unit (33) is in a home position, and the orientation position sensor (38) when the disc unit (33) has rotated to either one of two orientation positions by rotation in one or the other direction from the home position, and the direction disc (30) having a peripheral recess (34), which actuates the rotation direction sensor (32) in the home position and in one, but not the other, of the orientation positions.

## Patentansprüche

1. Verfahren zum Anordnen von Transporthülsen für elektronische Bauteile (28) in einer gewünschten Richtung, wobei die Transporthülsen (28) keinen kreisförmigen Querschnitt haben und das Verfahren umfaßt
a) das Zuführen der Transporthülsen (28) in einer Richtung quer zu ihrer Längsachse durch einen Spalt zwischen einem Führungsbauteil (13b) und einer sich drehenden Walze (13a), wobei der Spalt (G) ausreichend breit ist, um jeder Transporthülse (28) den Durchgang durch den Spalt (G) nur in zugelassenen Richtungen um die Längsachse der Transporthülse (28) zu erlauben,
b) das Feststellen, welche der zugelassenen Richtungen jede Transporthülse (28) beim Durchlaufen des Spalts (G) einnimmt, und
c) das Drehen der Transporthülse (28) um ihre Längsachse in die gewünschte Richtung, wenn die Richtung dieser Transporthülse (28) nicht die gewünschte Richtung ist.

2. Verfahren nach Anspruch 1, dadurch gekennzeichnet, daß die Walze (13a), die sich dreht, sich in eine Richtung gegen die Zuführrichtung der Transporthülse (28) bewegt, und zwar auf der Seite, die dem Führungsbauteil (13b) gegenüberliegt.

3. Verfahren nach Anspruch 1 oder 2, dadurch gekennzeichnet, daß das Führungsbauteil (13b) eine zweite Walze ist.

4. Verfahren nach Anspruch 3, dadurch gekennzeichnet, daß die sich drehende Walze (13a) sich fortlaufend in eine Richtung dreht und die zweite Walze (13b) sich abwechselnd in entgegengesetzte Richtungen dreht.

5. Verfahren nach irgendeinem der vorhergehenden Ansprüche, dadurch gekennzeichnet, daß die Schwerkraft die Transporthülsen (28) durch den Spalt (G) bewegt.

6. Verfahren nach irgendeinem der vorhergehenden Ansprüche, dadurch gekennzeichnet, daß die Transporthülsen (28) nach dem Durchlaufen des Spalts (G) in einem Speicher (3) gestapelt werden, der so angepaßt ist, daß die Richtung der Transporthülsen (28) erhalten bleibt.

7. Verfahren nach Anspruch 6, dadurch gekennzeichnet, daß der Speicher mit einem Sensor ausgestattet ist, der auf die Ausrichtung einer jeden Transporthülse (28) anspricht.

8. Verfahren nach irgendeinem der vorhergehenden Ansprüche, dadurch gekennzeichnet, daß das Ausrichten durch Drehen der Transporthülse (28) in eine Richtung ausgeführt wird, die abhängig vom Ausgangssignal des Sensors (14) festgelegt wird.

9. Verfahren nach irgendeinem der vorhergehenden Ansprüche, dadurch gekennzeichnet, daß das Ausrichten einer jeden Transporthülse (28) von einem Ausrichter (4) ausgeführt wird, der jede Transporthülse (28) einzeln aufnimmt und sie in die gewünschte Richtung dreht, wobei der Ausrichter (4) mit einer Drehstellungs-Erfaßvorrichtung verbunden ist, umfassend eine Scheibeneinheit (33), die sich zugleich mit dem Ausrichter dreht, und eine Anzahl Erfassungseinheiten (32, 36, 38) , die die Drehverschiebung der Scheibeneinheit (33) erfassen.

10. Verfahren nach Anspruch 9, dadurch gekennzeichnet,
daß die Scheibeneinheit (33) eine Stellungsscheibe (31) und eine Richtungsscheibe (30) umfaßt,
daß die Erfassungseinheit einen Ruhelagesensor (36) und einen Richtungsstellungssensor (38) umfaßt, die auf die Stellungsscheibe (31) ansprechen, und einen Drehrichtungssensor (32), der auf die Richtungsscheibe (30) anspricht,
wobei die Richtungsscheibe (31) am Rand Kerben (35) aufweist, die so angebracht sind, daß sie jeweils den Ruhelagesensor (36) betätigen, wenn sich die Scheibeneinheit (33) in einer Ruhestellung befindet, bzw. den Richtungsstellungssensor (38), wenn sich die Scheibeneinheit (33) durch Drehen in die eine oder die andere Richtung aus der Ruhestellung in eine der beiden Richtungsstellungen gedreht hat, und die Richtungsscheibe (30) am Rand eine Aussparung (34) hat, die den Drehrichtungssensor (32) in der Ruhelage und in einer Richtungsstellung betätigt, jedoch nicht in der anderen Richtungsstellung.

## Revendications

1. Procédé visant à placer des supports tubulaires pour dispositifs électroniques (28) dans une orientation voulue, les supports tubulaires (28) ayant une section droite non circulaire, le procédé comprenant les opérations suivantes :
(a) faire avancer les supports tubulaires (28), suivant une direction transverse par rapport à leur axe longitudinal, dans un intervalle ménagé entre un élément de guidage (13b) et un rouleau tournant (13a), l'intervalle (G) étant suffisamment large pour permettre à chaque support tubulaire (28) de passer dans l'intervalle (G) seulement dans des orientations permises par rapport à l'axe longitudinal du support tubulaire (28);
(b) déterminer laquelle des orientations permises est adoptée par chaque support tubulaire (28) lors du passage dans l'intervalle (G) ; et
(c) sauf si l'orientation d'un support tubulaire (28) est une orientation voulue, faire tourner ce support tubulaire (28) sur son axe longitudinal jusqu'à l'orientation voulue.

2. Procédé selon la revendication 1, caractérisé en ce que le rouleau tournant (13a), du côté qui regarde l'élément de guidage (13b), se déplace dans un sens qui va contre le sens d'avancement des supports tubulaires (28).

3. Procédé selon la revendication 1 ou 2, caractérisé en ce que l'élément de guidage (13b) est un deuxième rouleau.

4. Procédé selon la revendication 3, caractérisé en ce que le rouleau tournant (13a) tourne de façon continue dans un sens et le deuxième rouleau (13b) tourne alternativement dans des sens opposés.

5. Procédé selon l'une quelconque des revendications précédentes, caractérisé en ce que les supports tubulaires (28) se déplacent dans l'intervalle (G) sous l'action de la force de pesanteur.

6. Procédé selon l'une quelconque des revendications précédentes, caractérisé en ce que, après être passés dans l'intervalle (G), les supports tubulaires (28) s'empilent dans un butoir (3) qui est destiné à maintenir l'orientation des supports tubulaires (28).

7. Procédé selon la revendication 6, caractérisé en ce que le butoir est doté d'un capteur sensible à l'orientation de chaque support tubulaire (28).

8. Procédé selon l'une quelconque des revendications précédentes, caractérisé en ce que l'orientation est obtenue par rotation du support tubulaire (28) dans un sens qui est déterminé en fonction du signal de sortie du capteur (14).

9. Procédé selon l'une quelconque des revendications précédentes, caractérisé en ce que l'orientation de chaque support tubulaire (28) est obtenue au moyen d'un orientateur (4) qui reçoit chaque support tubulaire (28) l'un après l'autre et le fait tourner jusqu'à l'orientation voulue, l'orientateur (4) étant couplé à un dispositif de détection de position de rotation qui comprend une unité de disques (33), tournant en même temps que l'orientateur, et plusieurs unités de détection(32, 36, 38) qui détectent le déplacement de rotation de l'unité de disques (33).

10. Procédé selon la revendication 9, caractérisé en ce que l'unité de disques (33) comprend un disque de position (31) et un disque de direction (30), et en ce que l'unité de détection comprend un capteur de position de repos (36) et un capteur de position d'orientation (38), qui répondent au disque de position (31), ainsi qu'un capteur de sens de rotation (32) qui répond au disque de direction (30), le disque de position (31) possédant des encoches périphériques (35) qui sont respectivement disposées de façon à actionner le capteur de position de repos (36), lorsque l'unité de disques (33) est dans une position de repos, et le capteur de position d'orientation (38) lorsque l'unité de disque (33) a tourné jusqu'à l'une de deux positions d'orientation du fait d'une rotation dans l'un ou l'autre sens par rapport à la position de repos, et le disque de direction (30) possédant un évidement périphérique (34), qui actionne le capteur de sens de rotation (32) dans la position de repos et dans l'une, mais non l'autre, des positions d'orientation.
